(19) Europäisches Patentamt / European Patent Office / Office européen des brevets

(11) **EP 1 639 393 B1**

(12) **EUROPÄISCHE PATENTSCHRIFT**

(45) Veröffentlichungstag und Bekanntmachung des Hinweises auf die Patenterteilung:
**18.08.2010 Patentblatt 2010/33**

(51) Int Cl.:
*G02B 5/30* (2006.01)     *G02B 27/00* (2006.01)
*G02B 13/14* (2006.01)

(21) Anmeldenummer: 04739966.2

(22) Anmeldetag: **17.06.2004**

(86) Internationale Anmeldenummer:
**PCT/EP2004/006504**

(87) Internationale Veröffentlichungsnummer:
**WO 2005/001527 (06.01.2005 Gazette 2005/01)**

(54) **KORREKTUREINRICHTUNG ZUR KOMPENSATION VON STÖRUNGEN DER POLARISATIONSVERTEILUNG SOWIE PROJEKTIONSOBJEKTIV FÜR DIE MIKROLITHOGRAPHIE**

CORRECTIVE DEVICE FOR COMPENSATING DISTURBANCES OF POLARIZATION DISTRIBUTION, AND MICROLITHOGRAPHIC PROJECTION LENS

DISPOSITIF DE CORRECTION POUR LA COMPENSATION DE PERTURBATIONS DE LA REPARTITION DE POLARISATION, AINSI QU'OBJECTIF DE PROJECTION POUR LA MICROLITHOGRAPHIE

(84) Benannte Vertragsstaaten:
**AT BE BG CH CY CZ DE DK EE ES FI FR GB GR HU IE IT LI LU MC NL PL PT RO SE SI SK TR**

(30) Priorität: **27.06.2003 DE 10328938**

(43) Veröffentlichungstag der Anmeldung:
**29.03.2006 Patentblatt 2006/13**

(73) Patentinhaber: **Carl Zeiss SMT AG**
**73447 Oberkochen (DE)**

(72) Erfinder: **HEMBD, Christian**
**73035 Göppingen-Faurndau (DE)**

(74) Vertreter: **Schwanhäusser, Gernot et al**
**Ostertag & Partner**
**Patentanwälte**
**Epplestr. 14**
**70597 Stuttgart (DE)**

(56) Entgegenhaltungen:
**EP-A- 0 937 999     US-A- 3 663 087**

• **PATENT ABSTRACTS OF JAPAN Bd. 0173, Nr. 38 (P-1564), 25. Juni 1993 (1993-06-25) & JP 5 045519 A (FUJITSU LTD), 23. Februar 1993 (1993-02-23)**

**Beschreibung**

Die Erfindung betrifft eine Korrektureinrichtung zur Kompensation von Störungen der Polarisationsverteilung über den Querschnitt eines Lichtbündels in einem optischen System, mit mindestens einem Korrekturglied, das ein doppelbrechendes Korrekturelement mit zwei im wesentlichen parallelen Oberflächen umfaßt, zwischen denen die Dicke des Korrekturelements im wesentlichen konstant ist. Die Erfindung betrifft ferner ein Projektionsobjektiv für die Mikrolithographie mit einer derartigen Korrektureinrichtung.

Eine Korrektureinrichtung sowie ein Projektionsobjektiv dieser Art sind aus der DE 198 07 120 A1 bekannt.

Bei zahlreichen optischen Systemen ist Voraussetzung für eine hohe Abbildungsqualität, daß sich das durch das optische System hindurchtretende Licht über den gesamten Bündelquerschnitt hinweg in einem definierten Polarisationszustand befindet. Da dieser definierte Polarisationszustand nicht konstant über den Bündelquerschnitt sein muß, spricht man häufig auch von einer definierten Polarisationsverteilung des Lichts. Kommt es zu Abweichungen von dieser definierten Polarisationsverteilung, so kann dies zu nicht tolerierbaren Abbildungsfehlern und/oder zu Kontrastverlusten in der Bildebene führen. Als Ursachen für derartige Abweichungen kommen beispielsweise die Polarisationsabhängigkeit reflektierender Schichten oder die Doppelbrechung bestimmter Linsenmaterialien in Betracht.

Der letztgenannte Punkt hat besondere Bedeutung im Zusammenhang mit mikrolithographischen Projektionsbelichtungsanlagen erlangt, wie sie etwa zur Herstellung hochintegrierter elektrischer Schaltkreise verwendet werden. Dort kommen in zunehmendem Maße Linsen aus Flußspat ($CaF_2$) zum Einsatz, da diese Kristalle auch bei sehr kurzen Projektionslichtlängen noch eine ausreichende optische Transparenz aufweisen. Flußspat ist bei sehr kurzen Wellenlängen jedoch von Hause aus (d.h. intrinsisch) doppelbrechend; hinzutreten kann außerdem eine durch mechanische Spannungen hervorgerufene Doppelbrechung. Zwar sind inzwischen verschiedene Maßnahmen bekannt, um die Doppelbrechung von Flußspat-Linsen zu verringern, eine vollständige Kompensation von Störungen der Polarisationsverteilung über den Querschnitt des Projektionslichtbündels ist aber im allgemeinen nicht möglich. Bleiben diese Störungen unkompensiert, so verringert sich der Kontrast der Projektionsobjektive, was sich ungünstig auf die Größe der mit derartigen Anlagen gerade noch herstellbaren Strukturen auswirkt.

Dä die hier betrachteten Störungen der Polarisationsverteilung die Eigenschaft haben, über den Querschnitt eines Lichtbündels zu variieren, scheidet eine Kompensation mit herkömmlichen Polarisations-Kompensatoren, z.B. eines Soleil-Babinet-Kompensators, aus, da diese Kompensatoren gleichmäßig über den Querschnitt des Lichtbündels hinweg wirken.

Aus der eingangs bereits genannten DE 198 07 120 A1 ist eine Korrektureinrichtung zur Kompensation von Störungen der Polarisation bekannt, die über den Querschnitt eines Lichtbündels hinweg lokal variieren. Die dort beschriebene Korrektureinrichtung weist eine in den Strahlengang des optischen Systems eingebrachte Platte auf, die aus Magnesiumfluorid ($MgF_2$) besteht und somit doppelbrechend ist. Die Dicke der Platte variiert dabei über deren Querschnitt, wodurch sich eine ortsabhängige Kompensationswirkung ergibt. Da die zur Kompensation erforderlichen Dickenschwankungen nur wenige Mikrometer betragen, lassen sich die Freiformflächen auf der Platte nicht durch Polieren oder andere klassische Verfahren des Materialabtrags herstellen. Vorgeschlagen wird deswegen eine Herstellung der Freiformflächen im Wege der Ionenstrahl-Bearbeitung. Derartige Bearbeitungsverfahren werden beispielsweise bei der Herstellung von sog. "Nanoäsphären" eingesetzt, die zur Korrektur von Wellenfrontfehlern in Projektionsbelichtungsanlagen verwendet werden.

Um eine möglichst allgemeine Klasse von Polarisationsstörungen kompensieren zu können, wird die Verwendung zweier derartiger Platten vorgeschlagen, deren Hauptachsen um 45° zueinander verdreht sind. Da sich die Dickenschwankungen nicht nur auf die Polarisation, sondern in noch stärkerem Maße auf den Wellenfrontverlauf hindurchtretenden Lichts auswirken, ist jeder der Korrekturplatten eine Quarzplatte zur Wellenfrontkompensation zugeordnet, die ihrerseits Dikkenschwankungen aufweisen, die jedoch komplementär zu denen der Korrekturplatten verlaufen. Eine Korrekturplatte und die dazugehörige Quarzplatte, die spaltfrei durch Ansprengen oder Verketten miteinander verbunden werden, wirken sich in ihrer Gesamtheit aufgrund der annähernd gleichen Brechungsindizes kaum auf den Wellenfrontverlauf hindurchtretenden Lichts aus.

Nachteilig bei dieser bekannten Korrektureinrichtung ist allerdings, daß die Korrekturplatten die Polarisation nicht nur dort beeinflussen, wo Störungen kompensiert werden sollen, sondern die Polarisation über den gesamten Querschnitt des Lichtbündels verändern. Dies hängt damit zusammen, daß die Korrekturplatten nicht ausschließlich dort doppelbrechendes Material aufweisen können, wo eine Kompensation von Störungen der Polarisationsverteilung erforderlich ist. Die Korrekturplatten dürften dann nämlich nur wenige Mikrometer dick sein und wiesen zudem Löcher an den Stellen auf, an denen keine Störungen zu kompensieren sind. Derartige Korrekturplatten wären weder herstell- noch handhabbar. Daher müssen die Korrekturplatten zusätzliches, als eine Art Träger wirkendes Material aufweisen, das jedoch über seinen gesamten Querschnitt hinweg zur Polarisationsbeeinflussung beiträgt.

Aufgabe der Erfindung ist es, eine Korrektureinrichtung der eingangs genannten Art derart zu verbessern, daß die Polarisation hindurchtretenden Lichts gezielt nur dort beeinflußt wird, wo Störungen der Polarisationsverteilung zu kompensieren sind.

**EP 1 639 393 B1**

Gelöst wird diese Aufgabe dadurch, daß wenigstens ein Korrekturglied wenigstens ein dem einen Korrekturelement zugeordnetes weiteres doppelbrechendes Korrekturelement mit zwei im wesentlichen parallelen Oberflächen aufweist, daß wenigstens eine der Oberflächen wenigstens eines der Korrekturelemente so nachbearbeitet ist, daß sich lokale Dickenschwankungen Δd ergeben, durch die die Störungen der Polarisationsverteilung zumindest annähernd kompensiert werden, und daß die Anordnung, Dicke und Doppelbrechungseigenschaften der Korrekturelemente so gewählt sind, daß sich deren doppelbrechenden Wirkungen gegenseitig aufheben, wenn die lokalen Dickenschwankungen außer Betracht bleiben.

Die Erfindung beruht auf der Erkenntnis, daß mehrere doppelbrechende Elemente, deren Doppelbrechungsachsen in geeigneter Weise zueinander orientiert sind, sich in ihrer doppelbrechenden Wirkung aufheben. Die Erfindung geht also zunächst von einer Anordnung zweier oder mehrerer doppelbrechender Korrekturelemente aus, die insgesamt die Polarisation hindurchtretenden Lichts nicht beeinflussen. Wird nun an einem oder mehreren dieser Korrekturelemente die Dicke lokal verändert, so beschränkt sich die doppelbrechende Wirkung der gesamten Anordnung lediglich auf diejenigen Bereiche, in denen Dickenänderungen vorgenommen wurden. Falls die Korrekturelemente aus demselben doppelbrechenden Material bestehen, so müssen sie, abgesehen von den durch nachträgliche Bearbeitung eingebrachten Dickenschwankungen, die gleiche Dicke aufweisen, damit eine vollständige gegenseitige Kompensation der doppelbrechenden Wirkung eintritt.

Bei einem Korrekturglied, das aus zwei Korrekturelementen besteht, können diese beispielsweise mit um 90° zueinander verdrehten Doppelbrechungsachsen in der Korrektureinrichtung angeordnet sein. Bei drei Korrekturelementen kommt eine relative Orientierung der Doppelbrechungsachsen in 120°-Winkeln in Betracht.

Bei einer bevorzugten Ausgestaltung der Erfindung sind die Oberflächen der Korrekturelemente so komplementär zueinander nachbearbeitet, daß die Gesamtdicke aller Korrekturelemente eines Korrekturglieds über deren Querschnitt hinweg konstant ist. Da das Korrekturglied als Ganzes keine Dickenschwankungen aufweist, werden Wel-lenfrontfehler weitgehend vermieden. Dies gilt auch dann, wenn die einzelnen Korrekturelemente nicht unmittelbar aufeinander befestigt, sondern beabstandet voneinander in der Korrektureinrichtung angeordnet sind. Falls es sich bei den Korrekturelementen beispielsweise um ebene Scheiben handelt, so wirkt das gesamte Korrekturglied wie eine planparallele Platte, die zwar lokal die Polarisation, nicht aber nennenswert den Verlauf der Wellenfront beeinflußt. Auf zusätzliche Quarzplatten, die im Stand der Technik zum Ausgleichen der optischen Weglängenunterschiede auf Grund der Dickenschwankungen erforderlich sind, kann somit verzichtet werden.

Vorteilhaft bei dieser Ausgestaltung ist ferner, daß sich die zur Störungskompensation an einem bestimmten Punkt erforderliche lokale Dickenschwankung auf diese Weise zwangsläufig auf mehrere Korrekturelemente verteilt. Falls beispielsweise das Korrekturglied zwei Korrekturelemente umfaßt, so führt die komplementäre Nachbearbeitung der Oberflächen dazu, daß eine lokale Dickenschwankung Δd so auf die beiden Korrekturelemente verteilt wird, daß an dem entsprechenden Punkt die Dicke bei einem Korrekturelement um Δd/2 verringert und bei dem anderen Korrekturelement um Δd/2 vergrößert ist. Die Verteilung der Dickenschwankungen auf mehrere Korrekturelemente ist insbesondere bei größeren Dickenschwankungen vorteilhaft, da sich diese mit den bekannten Methoden der Nachbearbeitung wie Ionen- oder Atomstrahlätzen nur mit größeren Schwierigkeiten präzise erzeugen lassen.

Idealerweise soll die Korrektureinrichtung lediglich lokal die Polarisation beeinflussen, ansonsten aber nicht die Lichtausbreitung in dem optischen System verändern, in dem die Korrektureinrichtung eingebaut ist. Bei Strahlbündeln mit kleinem Aperturwinkel wird es vor diesem Hintergrund im allgemeinen ausreichen, die Korrekturelemente als planparallele Platten auszuführen, deren Umfang an die Geometrie des durchtretenden Lichtbündels angepaßt sein kann. Bei Lichtbündeln mit größeren Aperturwinkeln hingegen kommen auch Korrekturelemente mit gekrümmten, z.B. sphärischen, Oberflächen in Betracht.

Ein Anwendungsfall hierfür sind katadioptische Projektionsobjektive, die in der Regel einen in einer Pupillenebene angeordneten sphärischen Abbildungsspiegel enthalten. Um die Korrektureinrichtung möglichst nahe einer Pupillenfläche und damit in unmittelbarer Nähe der gekrümmten Spiegeloberfläche anzuordnen, ist eine Anpassung der Oberfläche der Korrekturelemente an die Spiegelkrümmung praktisch unvermeidbar. Eine Anordnung der Korrekturein-richtung in einer Pupillenebene ist deswegen generell bevorzugt, weil diese dann eine feldunabhängige Wirkung hat, so daß als Korrekturgröße ein mittlerer Polarisationsfehler im Feld angenommen werden kann.

Selbst bei über den Querschnitt hinweg konstanter Gesamtdicke aller Korrekturelemente sind allerdings geringfügige Wellenfrontfehler auf Grund der Dickenschwankungen der einzelnen Korrekturelemente nicht gänzlich vermeidbar. Aus diesem Grunde kann es zweckmäßig sein, daß wenigstens ein Korrekturelement eine Oberfläche aufweist, die zusätzlich derart nachbearbeitet ist, daß Wellenfrontfehler auf Grund der Dickenschwankungen verringert werden.

Mit lediglich einem Korrekturglied lassen sich nicht sämtliche Arten von Polarisationsstörungen kompensieren. Deswegen sind bei einer bevorzugten Ausgestaltung der Erfindung zwei Korrekturglieder vorgesehen, wobei die Doppelbrechungsachsen der Korrekturelemente des einen Korrekturglieds um 45° zu den Doppelbrechungsachsen der Korrekturelemente des anderen Korrekturglieds verdreht sind. Auf diese Weise lassen sich nicht nur Phasenverschiebungen, sondern auch Drehungen der Polarisation kompensieren.

Ausführungsbeispiele der Erfindung werden im folgenden anhand der Zeichnungen erläutert. Darin zeigen:

3

Figur 1      eine stark vereinfachte Darstellung der Polarisa- tionsverteilung über den Querschnitt eines Licht- bündels;

Figur 2      eine perspektivische, nicht maßstäbliche Darstel- lung einer erfindungsgemäßen Korrektureinrichtung mit zwei Korrekturelementen, die von einem Licht- bündel durchtreten werden;

Figur 3      einen Querschnitt durch die in Figur 2 gezeigten Korrekturelemente vor dem Zusammenfügen;

Figur 4      eine der Figur 3 entsprechende Darstellung, je- doch nach dem Zusammenfügen der Korrekturelemen- te;

Figur 5      einen Querschnitt durch ein anderes Ausführungs- beispiel einer erfindungsgemäßen Korrekturein- richtung mit drei Korrekturelementen;

Figur 6      einen Querschnitt durch ein weiteres Ausführungs- beispiel einer erfindungsgemäßen Korrekturein- richtung, die zwei Korrekturglieder mit jeweils zwei Korrekturelementen umfaßt;

Figur 7      einen vereinfachten Meridionalschnitt durch ein katadioptisches Projektionsobjektiv mit einer er- findungsgemäßen Korrektureinrichtung.

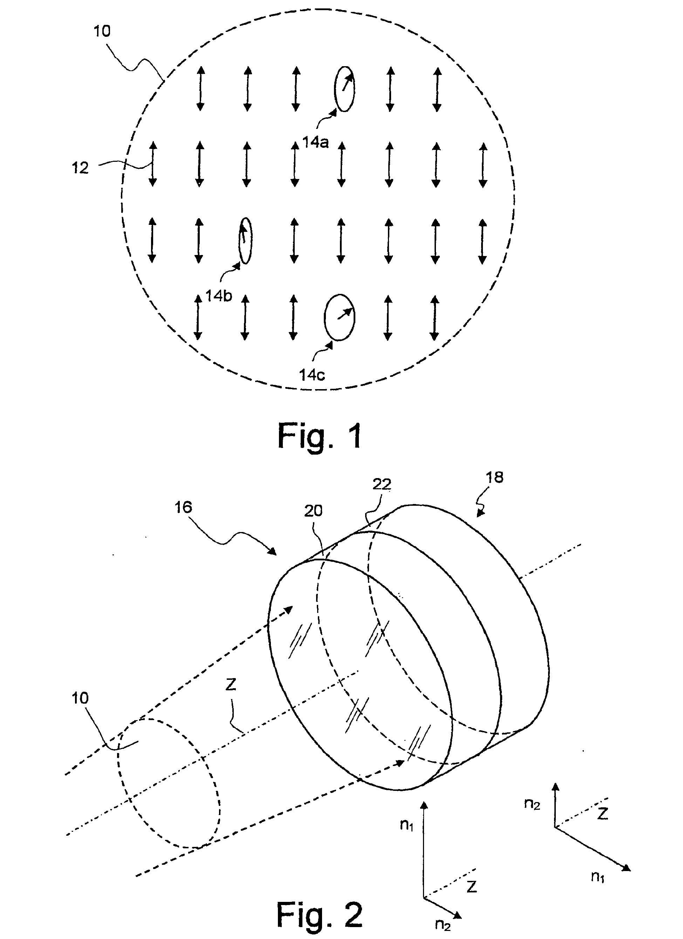

Figur 1 zeigt einen Querschnitt durch ein Lichtbündel 10, in dem schematisch eine Polarisationsverteilung mit Hilfe von Pfeilen 12 angedeutet ist. Die Pfeile 12 sollen dabei die Polarisationsrichtung innerhalb des Lichtbündels 10 darstellen. Wie in Figur 1 erkennbar, ist das Licht über den Querschnitt des Lichtbündels 10 hinweg überwiegend linear mit der gleichen Polarisationsrichtung polarisiert. An einigen Punkten, die in Figur 1 mit 14a, 14b und 14c bezeichnet sind, ist das Licht jedoch nicht exakt linear, sondern mehr oder weniger stark elliptisch polarisiert. Diese Störungen der Polarisationsverteilung können in nachfolgenden polarisationsselektiven optischen Elementen, z.B. Strahlteilerschichten oder Verzögerungsplättchen, zu nicht tolerierbaren Abbildungsfehlern und/oder zur einem Kontrastverlust in der Bildebene führen.

Figur 2 zeigt in einer perspektivischen, nicht maßstäblichen Darstellung eine Korrektureinrichtung 16, mit der die Störungen 14a, 14b und 14c in der Polarisationsverteilung des Lichtbündels 10 kompensiert werden können. Die Korrektureinrichtung 16 weist neben in Figur 2 nicht dargestellten Halterungselementen ein Korrekturglied 18 auf, das seinerseits ein erstes und ein zweites scheibenförmiges Korrekturelement 20 bzw. 22 umfaßt, die fugenlos zusammengefügt sind. Die beiden Korrekturelemente 20, 22 sind aus Magnesiumfluorid-Kristallen ($MgF_2$) gefertigt und daher doppelbrechend. Magnesiumfluorid ist insbesondere für Anwendungen in der Mikrolithographie geeignet, da es auch bei den dort verwendeten Wellenlängen von 193 nm oder 157 nm noch transparent ist.

Die Orientierung der Kristallachsen ist dabei so gewählt, daß sich für die beiden Korrekturelemente 20, 22 die in Figur 2 durch Achsenkreuze dargestellten Doppelbrechungsachsen ergeben. Die langsame Kristallachse mit dem größeren Brechungsindex $n_1$ und die schnelle Kristallachse mit dem kleineren Brechungsindex $n_2$ stehen jeweils senk- recht aufeinander und außerdem senkrecht zu der mit Z bezeichneten optischen Achse der Korrektureinrichtung 16.

Dies bedeutet, daß in dem ersten Korrekturelement 20 eine Polarisationskomponente des Lichtbündels 10, die entlang der langsamen Kristallachse verläuft, gegenüber der dazu senkrechten Polarisationskomponente eine auch als Verzögerung bezeichnete Phasenänderung Φ erfährt, die durch

$$\Phi = (2\pi/\lambda) \cdot d \cdot (n_1 - n_2)$$

gegeben ist. Darin bezeichnet λ die Wellenlänge des auf das Korrekturglied 18 auftreffenden Lichts und d die Dicke des Korrekturelements 20 entlang der optischen Achse Z.

In dem zweiten Korrekturelement 22 hingegen wird die hierzu senkrechte Polarisationskomponente verzögert, da die Kristallorientierungen der Korrekturelemente 20, 22 und damit deren Doppelbrechungsachsen um 90° um die Z- Achse zueinander verdreht sind. Da die beiden Korrekturelemente 20, 22 die gleiche Dicke haben, ist der Betrag der Phasenänderungen gleich. Auf diese Weise wird die durch das erste Korrekturelement 20 hervorgerufene Phasenänderung der einen Polarisationskomponente durch eine gleich große, durch das zweite Korrekturelement 22 hervorgerufene Phasenänderung der dazu senkrechten Polarisationskomponente kompensiert. Dort, wo die Dicken der beiden Korrekturelemente 20, 22 exakt gleich sind, wird somit die relative Phasenlage zwischen zueinander senkrechten Polarisationskomponenten und somit der Polarisationszustand des hindurchtretenden Lichts nicht verändert.

Um nun die in Figur 1 schematisch gezeigten Störungen der Polarisationsverteilung zu kompensieren, sind über den Querschnitt hinweg an geeignet gewählten Punkten die Dicken der beiden Korrekturelemente 20, 22 bewußt abweichend gewählt.

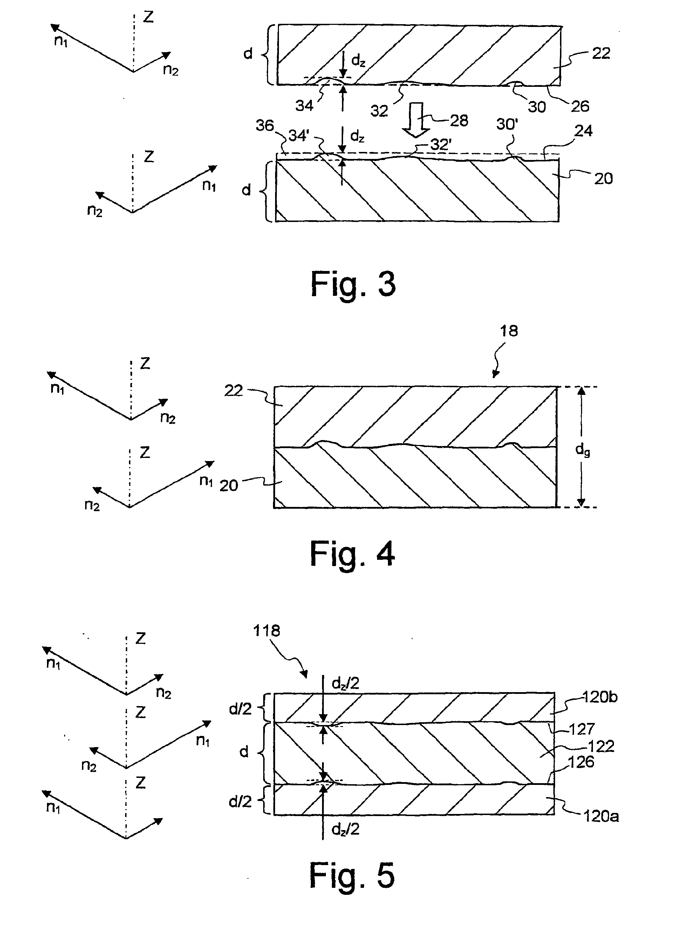

Figur 3 zeigt einen Querschnitt durch die beiden Korrekturelemente 20, 22 vor dem Zusammenfügen. In stark übertriebener Darstellung sind dabei auf den einander zugewandten Oberflächen 24 und 26 der beiden Korrekturelemente 20, 22 zu Dickenschwankungen führende Strukturen zu erkennen, die komplementär zueinander ausgebildet sind. Dies bedeutet, daß zu jeder Erhöhung auf einer Oberfläche eine Ausnehmung auf der gegenüberliegenden Oberfläche korrespondiert, und daß die korrespondierenden Erhöhungen und Ausnehmungen so ausgebildet sind, daß sie beim Zusammenfügen der beiden Korrekturelemente 20, 22 paßgenau ineinander eingreifen. Durch das mit einem Pfeil 28 angedeutete Zusammenführen der beiden Korrekturelemente 20, 22 entsteht dann das in Figur 4 gezeigte Korrekturglied 18, das aus einem Materialblock mit gleichmäßiger Gesamtdicke $d_g$ besteht, der keinerlei Hohlräume enthält.

Wie in Figur 3 erkennbar ist, haben beide Korrekturelemente 20, 22 bei Außerbetrachtlassen der Dickenschwankungen die gleiche Dicke d, um die oben im Zusammenhang mit der Figur 2 erläuterte Grundkompensation der Phasenänderungen zu erzielen. An der Oberfläche 26 des zweiten Korrekturelements 22 sind durch Ionenstrahlätzen oder ähnliche geeignete Bearbeitungsverfahren nachträglich mehrere Ausnehmungen 30, 32 und 34 eingearbeitet, um an dieser Stelle eine Störung der Polarisationsverteilung zu kompensieren. Die gegenüberliegende Oberfläche 24 des ersten Korrekturelements 20 weist entsprechende Erhöhungen 30', 32' und 34' auf, deren Form exakt derjenigen der gegenüberliegenden Ausnehmungen entspricht. Die Erhöhungen 30', 32' und 34' werden erzeugt, indem zunächst das erste Korrekturelement 20 mit einem gestrichelt angedeuteten Dickenvorhalt 36 hergestellt wird, so daß durch nachträgliches Abtragen von Material um die Erhöhungen 30', 32' und 34' herum diese freigelegt werden können.

Es versteht sich, daß die hier vorgenommene Einteilung in Ausnehmungen 30, 32, 34 einerseits und Erhöhungen 30', 32', 34' andererseits lediglich dazu dient, die Darstellung zu vereinfachen. Ob man die Oberfläche 26 des zweiten Korrekturelements 22 durch die Ausnehmungen 30, 32, 34 oder aber durch Erhöhungen definiert, die zwischen den Ausnehmungen 30, 32, 34 liegen, ist lediglich eine Frage der Definition. Ganz allgemein können die Oberflächen 24, 26 der Korrekturelemente 20 bzw. 22 eine praktisch beliebige, jedoch zueinander komplementäre Welligkeit aufweisen.

Um Lage und Ausmaß der Dickenschwankungen festzulegen, kann beispielsweise wie folgt vorgegangen werden:

Zunächst wird in einer Bildebene des optischen Systems, in dem die Korrektureinrichtung 16 eingebaut ist, die Polarisationsverteilung meßtechnisch aufgenommen. Hierzu werden in einer Objektebene des optischen Systems nacheinander zwei orthogonale Polarisationen eingestellt und jeweils in der Bildebene der Polarisationszustand erfaßt. Aus der Differenz der Meßergebnisse errechnet sich der Korrekturbedarf in Abhängigkeit von der optischen Lage des Korrekturglieds 18. Befindet sich das Korrekturglied 18 in einer Pupillenebene des optischen Systems, so ist die Wirkung des Korrekturgliedes 18 feldunabhängig. Dadurch ist es möglich, den mittleren Polarisationsfehler im Feld als Korrekturgröße zu verwenden. Wenn mit $\Phi(\theta,\varphi)$ die Phasendifferenz zwischen den beiden senkrechten Polarisationszuständen in Abhängigkeit von den Winkelkoordinaten $\theta$ und $\varphi$ von Strahlen in der Bildebene bezeichnet wird, so ergibt sich die erforderliche Dickenschwankung $\Delta d$ eines Korrekturelements an den Ortskoordinaten (x,y) aus

$$\Delta d(x,y) = \Phi(\theta,\varphi) \cdot (\lambda/2\pi) \cdot 1/(n_1 - n_2) \quad .$$

Da eine Dickenschwankung $\Delta d(x,y)$ an einem Ort (x,y) bei dem in den Figuren 2 bis 4 gezeigten Ausführungsbeispiel jeweils gleichmäßig auf die beiden Korrekturelemente 20, 22 verteilt wird, um die Gesamtdicke $d_g$ konstant zu halten, führt dies bei den beiden Korrekturelementen 20, 22 an dem Ort (x,y) zu einer Erhöhung bzw. Ausnehmung um einen Betrag von $d_z = \Delta d/2$. Diese Größe $d_z$, die herstellungstechnisch die Höhe des erforderlichen Materialabtrags angibt, wird im folgenden als Profiltiefe bezeichnet. Die Tatsache, daß die Profiltiefe gegenüber der erforderlichen Dickenschwankung $\Delta d$ um den Faktor 2 verringert ist, hat erhebliche herstellungstechnische Vorteile, da es mit den bisher bekannten Verfahren zum hochgenauen Materialabtrag bisweilen Schwierigkeiten bereitet, große Profiltiefen zu erzielen.

In Figur 3 ist die Profiltiefe $d_z$ beispielhaft für den Ort mit der größten bzw. der geringsten Dicke der Korrekturelemente 20, 22 eingezeichnet. Aus dieser Darstellung ergibt sich auch, daß der Dickenvorhalt 36 auf dem ersten Korrekturelement 20 so gewählt werden sollte, daß er (mindestens) gleich der maximalen Profiltiefe und somit der Hälfte der maximalen Dickenschwankung $\Delta d$ ist, die zur Störungskompensation erforderlich ist.

Die sich auf diese Weise ergebenden Profiltiefen $d_z$ liegen bei einer Anwendung des Korrekturelements 16 in der Mikrolithographie mit Wellenlängen von 193 nm oder 157 nm in der Größenordnung von einigen hundert Nanometern, während die Dicken d der Scheiben in der Größenordnung einiger Millimeter liegen. Die in Figur 3 dargestellten Profiltiefen $d_z$ sind somit stark übertrieben dargestellt.

Figur 5 zeigt ein anderes Ausführungsbeispiel einer Korrektureinrichtung, die insgesamt mit 118 bezeichnet ist. Teile, die denen des in den Figuren 2 bis 4 gezeigten Ausführungsbeispiels entsprechen, sind dabei mit um 100 erhöhten Bezugsziffern versehen. Bei diesem Ausführungsbeispiel ist das erste Korrekturelement in zwei Teilelemente 120a, 120b aufgeteilt, die zwischen sich das zweite Korrekturelement 122 einschließen und deren Gesamtdicke derjenigen des zweiten Korrekturelements 122 entspricht. Die Dickenschwankungen $\Delta$d sind hier auf zwei Grenzflächen aufgeteilt, die durch die im wesentlichen parallelen Oberflächen 126, 127 des zweiten Korrekturelements 122 festgelegt sind. Dadurch halbiert sich für jede dieser Oberflächen 126, 127 die Profiltiefe nochmals um einen Faktor 2 auf $d_z/2 = \Delta d/4$.

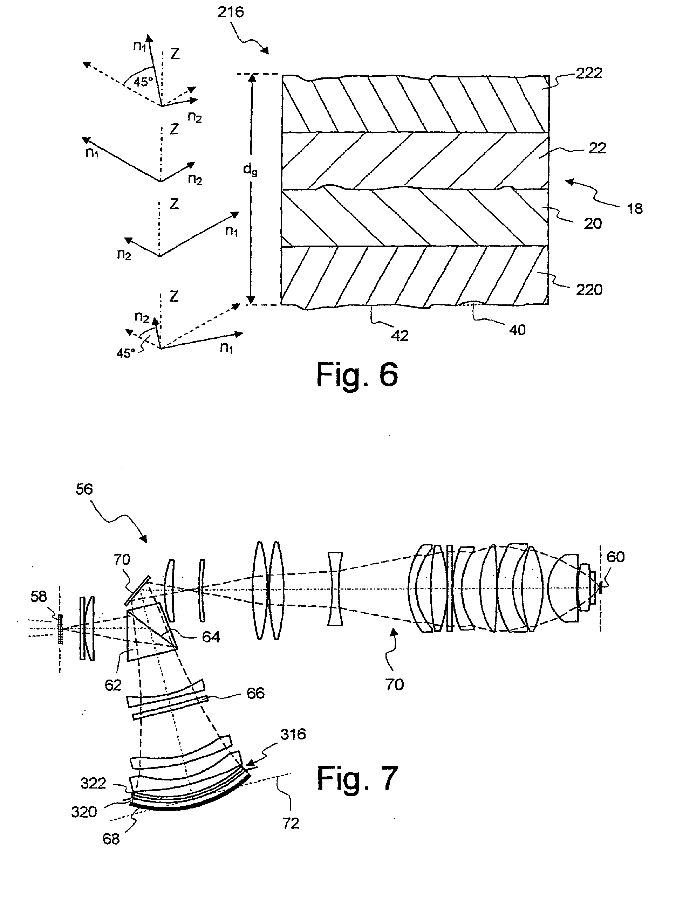

Figur 6 zeigt in einem Querschnitt ein weiteres Ausführungsbeispiel für eine Korrektureinrichtung, die insgesamt mit 216 bezeichnet ist. Die Korrektureinrichtung 216 umfaßt zum einen das Korrekturglied 18, wie es in den Figuren 2 bis 4 gezeigt ist. Ferner enthält die Korrektureinrichtung 216 zwei weitere Korrekturelemente 220 und 222, die gemeinsam ein weiteres Korrekturglied bilden. Wie links neben dem Querschnitt dargestellt ist, gehen die Orientierungen der Kristallachsen der beiden Korrekturelemente 220 und 222 durch eine Drehung um 45° aus den Kristallachsen der Korrekturelemente 20 bzw. 22 hervor. Dadurch stehen auch bei den beiden äußeren Korrekturelementen 220, 222 die schnellen Kristallachsen und auch die die langsamen Kristallachsen jeweils senkrecht aufeinander. Auf diese Weise kompensieren sich, wenn Dickenschwankungen zunächst unberücksichtigt bleiben, die beiden äußeren Korrekturelemente 220, 222 vollständig in ihrer Wirkung auf die Polarisation hindurchtretenden Lichts.

Wie in Figur 6 übertrieben dargestellt ist, weisen auch die äußeren Korrekturelemente 40 und 42 Dickenschwankungen auf, die in der oben bereits beschriebenen Weise zueinander komplementär sind. Auf Grund ihrer Anordnung an gegenüberliegenden Seiten des Korrekturgliedes 18 können die dadurch entstehenden Ausnehmungen und Erhöhungen jedoch nicht miteinander in Eingriff gebracht werden. Die Gesamtdicke $d_g$ der Korrektureinrichtung 216 ist jedoch an jeder Koordinate (x,y) die identisch.

Da die Doppelbrechungsachsen des durch die beiden äußeren Korrekturelemente 220, 222 gebildeten Korrekturglieds um 45° gegenüber den Doppelbrechungsachsen des Korrekturglieds 18 verdreht sind, lassen sich durch die Korrektureinrichtung 216 nicht nur Phasenverschiebungen, sondern auch Drehungen der Polarisationsrichtung kompensieren. Um in diesem allgemeinen Fall die Anordnung und Größe der Dickenschwankungen auf den einzelnen Korrekturelementen 20, 22, 220 und 222 zu bestimmen, wird vorzugsweise für jeden Feldpunkt und für jede Winkelkoordinate die Jonesmatrix als Linearkombination von Elementarmatrizen dargestellt, die Phasenverschiebungen und Drehungen der Polarisation beschreiben. Durch Gleichsetzen der so dargestellten Jonesmatrix für jeden Feldpunkt mit einer Jonesmatrix für die in Figur 6 gezeigte Anordnung, die lediglich phasenverschiebende Elemente enthält, kann durch Koeffizientenvergleich auf die Größe der Dickenschwankungen an den Punkten (x,y) auf den Oberflächen der Korrekturelemente geschlossen werden.

Mit 40 ist in Figur 6 beispielhaft und ebenfalls nicht maßstäblich ein zusätzlicher Materialabtrag angedeutet, der lediglich an einer nach außen weisenden Oberfläche 42 des Korrekturelements 220 vorhanden ist und keine Entsprechung in Form einer korrespondierenden Erhöhung an dem zugeordneten Korrekturelement 222 hat. Dieser Materialabtrag dient dazu, bei der Polarisationskompensation auftretende kleine Wellenfrontfehler zu beseitigen. Dabei wird ausgenutzt, daß sich ein Materialabtrag bei $MgF_2$ etwa hundertmal stärker auf die Wellenfront auswirkt als auf die Polarisation.

Figur 7 zeigt in einem vereinfachten Meridionalschnitt ein katadioptisches, insgesamt mit 56 bezeichnetes Projektionsobjektiv einer mikrolithographischen Projektionsbelichtungsanlage. Das Projektionsobjektiv 56 dient dazu, in einem Retikel 58 enthaltene Strukturen verkleinert auf einer lichtempfindlichen Oberfläche abzubilden, die auf einem Substrat 60 aufgebracht ist. Durch das Retikel 58 hindurchtretendes Projektionslicht tritt in einen Strahlteilerwürfel 62 ein, wird dort an einer polarisationsselektiven Strahlteilerschicht 64 reflektiert und über ein Viertelwellenlängenplättchen 66 und mehrere Linsen auf einen sphärischen Abbildungsspiegel 68 geworfen. Nach Reflektion an dem Abbildungsspiegel 68 wird die Polarisation erneut in dem Viertelwellenlängenplättchen 66 gedreht, so daß das Projektionslicht nunmehr die Strahlteilerschicht 64 durchdringen und in einen rein dioptischen Teil 70 des Projektionsobjektivs 60 gelangen kann.

Der sphärische Abbildungsspiegel 68 ist in der Nähe einer Pupillenebene 72 des Projektionsobjektivs 60 angeordnet. Unmittelbar vor dem Abbildungsspiegel 68, d.h. ebenfalls in der Nähe der Pupillenebene 72, ist eine Korrektureinrichtung 316 angeordnet, die zwei sphärisch gekrümmte Korrekturelemente 320, 322 umfaßt. Durch die Krümmung ist sichergestellt, daß die Korrektureinrichtung nicht zu weit von der Pupillenebene 72 entfernt angeordnet ist. Außerdem wirkt sich die Korrektureinrichtung 316 auf diese Weise weniger auf den Wellenfrontverlauf von unter großem Aperturwinkel auftreffenden Strahlen aus. Da aufgrund der Reflexion an dem Abbildungsspiegel 68 jeder Projektionslichtstrahl die Korrektureinrichtung 316 zweimal durchtritt, können die Dickenschwankungen $\Delta$d um einen Faktor 2 im Vergleich zu einer Anordnung reduziert werden, bei der nur ein einmaliger Durchtritt durch das Korrekturelement stattfindet.

## Patentansprüche

1. Korrektureinrichtung zur Kompensation von Störungen
   der Polarisationsverteilung über den Querschnitt eines Lichtbündels (10) in einem optischen System (56), mit mindestens einem Korrekturglied (18; 118), das ein doppelbrechendes Korrekturelement (22; 122; 222; 322) mit zwei im wesentlichen parallelen Oberflächen (26; 126, 127) umfaßt, zwischen denen die Dicke (d) des Korrekturelements (22, 122, 222) im wesentlichen konstant ist, wobei

das wenigstens eine Korrekturglied (18, 118) wenigstens ein dem einen Korrekturelement (22; 122; 222; 322) zugeordnetes weiteres doppelbrechendes Korrekturelement (20; 120a, 120b; 220; 320) mit zwei im wesentlichen parallelen Oberflächen (24) aufweist, und wenigstens eine der Oberflächen (24, 26; 126, 127) wenigstens eines der Korrekturelemente (20, 22; 120a, 120b, 122; 220; 222; 320, 322) so nachbearbeitet ist, daß sich lokale Dickenschwankungen $\Delta d$ ergeben, durch die die Störungen der Polarisationsverteilung zumindest annähernd kompensiert werden, **dadurch gekennzeichnet, daß** die Anordnung, Dicke (d) und Doppelbrechungseigenschaften der Korrekturelemente (20, 22; 120a, 120b, 122; 220; 222; 320, 322) so gewählt sind, daß sich deren doppelbrechenden Wirkungen gegenseitig aufheben, wenn die lokalen Dickenschwankungen $\Delta d$ außer Betracht bleiben.

2. Korrektureinrichtung nach Anspruch 1, **dadurch gekennzeichnet, daß** die Korrekturelemente (20, 22; 120a, 120b, 122; 220; 222; 320, 322) aus demselben Material bestehen.

3. Korrektureinrichtung nach Anspruch 2, **dadurch gekennzeichnet, daß** die Oberflächen (24, 26; 126, 127) der Korrekturelemente (20, 22; 120a, 120b, 122; 220; 222; 320, 322) so komplementär zueinander nachbearbeitet sind, daß die Gesamtdicke ($d_g$) aller Korrekturelemente (20, 22; 120a, 120b, 122; 220; 222; 320, 322) eines Korrekturglieds (18; 118) über deren Querschnitt hinweg konstant ist.

4. Korrektureinrichtung nach Anspruch 3, **dadurch gekennzeichnet, daß** das Korrekturglied (18; 118) zwei Korrekturelemente umfaßt und daß die zur Störungskompensation an einem bestimmten Punkt erforderliche lokale Dickenschwankung $\Delta d$ so verteilt ist, daß an diesem Punkt die Dikke (d) bei einem Korrekturelement (22) um $\Delta d/2$ verringert und bei dem anderen Korrekturelement (20) um $\Delta d/2$ vergrößert ist.

5. Korrektureinrichtung nach einem der vorhergehenden Ansprüche, **dadurch gekennzeichnet, daß** die Oberflächen der Korrekturelemente (320, 322) gekrümmt sind.

6. Korrektureinrichtung nach einem der vorhergehenden Ansprüche, **dadurch gekennzeichnet, daß** das Korrekturglied (18, 118) zwei Korrekturelemente (20, 22; 120a, 120b, 122; 220; 222; 320, 322) umfaßt, deren Doppelbrechungsachsen zueinander um 90° verdreht sind.

7. Korrektureinrichtung nach einem der vorhergehenden Ansprüche, **dadurch gekennzeichnet, daß** wenigstens ein Korrekturelement (220) eine Oberfläche aufweist, die zusätzlich derart nachbearbeitet (40) ist, daß Wellenfrontfehler aufgrund der Dickenschwankungen verringert werden.

8. Korrektureinrichtung nach einem der vorhergehenden Ansprüche, **dadurch gekennzeichnet, daß** zwei Korrekturglieder (18, 220 und 222) vorgesehen sind, wobei die Doppelbrechungsachsen der Korrekturelemente (20, 22) des einen Korrekturglieds (18) um 45° zu den Doppelbrechungsachsen der Korrekturelemente (220, 222) des anderen Korrekturglieds verdreht sind.

9. Projektionsobjektiv für die Mikrolithographie mit einer Korrektureinrichtung (316) nach einem der vorhergehenden Ansprüche.

10. Projektionsobjektiv nach Anspruch 9, **dadurch gekennzeichnet, daß** die Korrektureinrichtung (316) zumindest annähernd in einer Pupillenebene (72) des Projektionsobjektivs (56) angeordnet ist.

11. Projektionsobjektiv nach Anspruch 10, **dadurch gekennzeichnet, daß** die Korrektureinrichtung (316) in unmittelbarer Nähe eines Abbildungsspiegels (68) angeordnet ist, der in einem katadioptischen Teil des Projektionsobjektivs (56) enthalten ist.

12. Projektionsobjektiv nach Anspruch 10 oder 11, **dadurch gekennzeichnet, daß** eine weitere Korrektureinrichtung nach einem der Ansprüche 1 bis 8 zumindest annähernd in einer Feldebene des Projektionsobjektivs (56) angeordnet ist.

**EP 1 639 393 B1**

**Claims**

1. Correcting device to compensate for perturbations of the polarization distribution over the cross section of a light beam (10) in an optical system (56), comprising at least one correcting component (18; 118) which comprises a birefringent correcting element (22; 122; 222; 322) having two essentially parallel surfaces (26; 126, 127), between which the thickness (d) of the correcting element (22; 122, 222) is substantially constant, wherein the at least one correcting component (18, 118) comprises at least one further birefringent correcting element (20; 120a, 120b; 220; 320), which is associated with the first correcting element (22; 122; 222; 322) and has two substantially parallel surfaces (24), and at least one of the surfaces (24, 26; 126, 127) of at least one of the correcting elements (20, 22; 120a, 120b, 122; 220; 222; 320, 322) is reprocessed so as to create local thickness variations Δd by which the perturbations of the polarization distribution are compensated for at least approximately, **characterized in that** the arrangement, thickness (d) and birefringence properties of the correcting elements (20, 22; 120a, 120b, 122; 220; 222; 320, 322) are selected so that their birefringent effects cancel each other out when the local thickness variations Δd are neglected.

2. Correcting device according to Claim 1,
   **characterized in that** the correcting elements (20, 22; 120a, 120b, 122; 220; 222; 320, 322) consist of the same material.

3. Correcting device according to Claim 2,
   **characterized in that** the surfaces (24, 26; 126, 127) of the correcting elements (20, 22; 120a, 120b, 122; 220; 222; 320, 322) are reprocessed complementarily with one another so that the total thickness ($d_g$) of all the correcting elements (20, 22; 120a, 120b, 122; 220; 222; 320, 322) of a correcting component (18; 118) is constant over its cross section.

4. Correcting device according to Claim 3,
   **characterized in that** the correcting component (18; 118) comprises two correcting elements, and **in that** the local thickness variation Δd required for the perturbation compensation at a particular point is distributed so that the thickness (d) of one correcting element (22) is reduced by Δd/2 at this point, and that of the other correcting element (20) is increased by Δd/2.

5. Correcting device according to one of the preceding claims, **characterized in that** the surfaces of the correcting elements (320, 322) are curved.

6. Correcting device according to one of the preceding claims, **characterized in that** the correcting component (18, 118) comprises two correcting elements (20, 22; 120a, 120b, 122; 220; 222; 320, 322) whose birefringence axes are mutually rotated by 90°.

7. Correcting device according to one of the preceding claims, **characterized in that** at least one correcting element (220) has a surface which is additionally reprocessed (40) so as to reduce wavefront errors due to the thickness variations.

8. Correcting device according to one of the preceding claims, **characterized in that** two correcting components (18, 220 and 222) are provided, the birefringence axes of the correcting elements (20, 22) of one correcting component (18) being rotated by 45° relative to the birefringence axes of the correcting elements (220, 222) of the other correcting component.

9. Projection objective for microlithography, comprising a correcting device (316) according to one of the preceding claims.

10. Projection objective according to Claim 9,
    **characterized in that** the correcting device (316) is arranged at least approximately in a pupil plane (72) of the projection objective (56).

11. Projection objective according to Claim 10,
    **characterized in that** the correcting device (316) is arranged in the immediate vicinity of an imaging mirror (68), which is contained in a catadioptric part of the projection objective (56).

**12.** Projection objective according to Claim 10 or 11,
**characterized in that** a further correcting device according to one of Claims 1 to 8 is arranged at least approximately in a field plane of the projection objective (56).

## Revendications

**1.** Dispositif de correction pour la compensation de perturbations de la répartition de polarisation sur la section transversale d'un faisceau lumineux (10) dans un système optique (56), avec au moins un organe de correction (18 ; 118) qui comprend un élément de correction biréfringent (22 ; 122 ; 222 ; 322) avec deux surfaces essentiellement parallèles (26 ; 126, 127), entre lesquelles l'épaisseur (d) de l'élément de correction (22, 122, 222) est essentiellement constante, ledit au moins un organe de correction (18 ; 118) présentant au moins un autre élément de correction biréfringent (20 ; 120a, 120b ; 220 ; 320) associé au premier élément de correction (22 ; 122 ; 222 ; 322), avec deux surfaces essentiellement parallèles (24), et au moins une des surfaces (24, 26 ; 126, 127) d'au moins un des éléments de correction (20, 22 ; 120a, 120b, 122 ; 220 ; 222 ; 320, 322) étant rectifiée de façon à produire des variations locales d'épaisseur $\Delta d$, par lesquelles les perturbations de la répartition de polarisation sont compensées au moins approximativement, **caractérisé en ce que** la disposition, l'épaisseur (d) et les propriétés de biréfringence des éléments de correction (20, 22 ; 120a, 120b, 122 ; 220 ; 222 ; 320, 322) sont choisies de façon que leurs effets biréfringents s'annulent mutuellement si les variations locales d'épaisseur $\Delta d$ ne sont pas prises en considération.

**2.** Dispositif de correction selon la revendication 1, **caractérisé en ce que** les éléments de correction (20, 22 ; 120a, 120b, 122 ; 220 ; 222 ; 320, 322) sont composés du même matériau.

**3.** Dispositif de correction selon la revendication 2, **caractérisé en ce que** les surfaces (24, 26 ; 126, 127) des éléments de correction (20, 22 ; 120a, 120b, 122 ; 220 ; 222 ; 320, 322) sont rectifiées de manière mutuellement complémentaire de façon que l'épaisseur totale ($d_g$) de tous les éléments de correction (20, 22 ; 120a, 120b, 122 ; 220 ; 222 ; 320, 322) d'un organe de correction (18 ; 118) soit constante sur toute leur section transversale.

**4.** Dispositif de correction selon la revendication 3, **caractérisé en ce que** l'organe de correction (18 ; 118) comprend deux éléments de correction et que la variation locale d'épaisseur $\Delta d$ nécessaire pour la compensation des perturbations en un certain point est répartie de façon qu'en ce point l'épaisseur (d) soit diminuée de $\Delta d/2$ sur un élément de correction (22) et augmentée de $\Delta d/2$ sur l'autre élément de correction (20).

**5.** Dispositif de correction selon une des revendications précédentes, **caractérisé en ce que** les surfaces des éléments de correction (320, 322) sont courbes.

**6.** Dispositif de correction selon une des revendications précédentes, **caractérisé en ce que** l'organe de correction (18, 118) comprend deux éléments de correction (20, 22 ; 120a, 120b, 122 ; 220 ; 222 ; 320, 322) dont les axes de biréfringence sont tournées de 90° l'un par rapport à l'autre.

**7.** Dispositif de correction selon une des revendications précédentes, **caractérisé en ce qu'**au moins un élément de correction (220) présente une surface qui est rectifiée (40) en plus de façon à diminuer les erreurs de front d'onde dues aux variations d'épaisseur.

**8.** Dispositif de correction selon une des revendications précédentes, **caractérisé en ce que** deux organes de correction (18, 220 et 222) sont prévus, les axes de biréfringence des éléments de correction (20, 22) d'un organe de correction (18) étant tournés de 45° par rapport aux axes de biréfringence des éléments de correction (220, 222) de l'autre organe de correction.

**9.** Objectif de projection pour la microlithographie avec un dispositif de correction (316) selon une des revendications précédentes.

**10.** Objectif de projection selon la revendication 9, **caractérisé en ce que** le dispositif de correction (316) est disposé au moins approximativement dans un plan de pupille (72) de l'objectif de projection (56).

**11.** Objectif de projection selon la revendication 10, **caractérisé en ce que** le dispositif de correction (316) est disposé à proximité immédiate d'un miroir imageur (68) qui est contenu dans une partie catadioptrique de l'objectif de projection (56).

**12.** Objectif de projection selon la revendication 10 ou 11, **caractérisé en ce qu'**un autre dispositif de correction selon une des revendications 1 à 8 est disposé au moins approximativement dans un plan de champ de l'objectif de projection (56).

Fig. 1

Fig. 2

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19807120 A1